(19) Europäisches Patentamt
European Patent Office
Office européen des brevets

(11) **EP 3 620 941 A1**

(12) **EUROPEAN PATENT APPLICATION**

(43) Date of publication:
**11.03.2020 Bulletin 2020/11**

(51) Int Cl.:
**G06F 17/50** (2006.01)  **G06T 7/11** (2017.01)
**G06T 7/143** (2017.01)

(21) Application number: **18192627.0**

(22) Date of filing: **05.09.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **3FROG NV**
**2800 Mechelen (BE)**

(72) Inventors:
• **Coudron, Inge**
**2500 Lier (BE)**
• **Hannaert, Jurgen**
**1745 Opwijk (BE)**

(74) Representative: **IP HILLS NV**
**Hubert Frère-Orbanlaan 329**
**9000 Gent (BE)**

(54) **GENERATING A SPATIAL MODEL OF AN INDOOR STRUCTURE**

(57) According to an embodiment computer implemented method for generating a spatial model (500) of an indoor structure from a point cloud (100), the method comprising the steps of identifying (602) shapes in the point cloud (100); enveloping (603) the shapes by a bounding volume (300); intersecting (604) the bounding volume (300) with planes determined by the shapes, thereby obtaining structural faces (400, 410, 420); and constructing (606) the spatial model (500) by the structural faces.

Fig. 2

EP 3 620 941 A1

## Description

### Technical Field

The present invention relates to a system and method for generating from scanned data a spatial model of an indoor structure, such as an interior of a building.

### Background

An interior of a building comprises a variety of different spaces and surfaces, like, for example, rooms, hallways, window-panes, floors and ceilings. In the spaces of a building, a diversity of furniture and other accessories are placed for reasons of comfort, taste, and cosiness, or even structural necessity. Examples are couches, chairs, armatures, beams and many other elements, whether fixed to the building structure or not. The interior of a building is thus a unique composition depending on, among others, the purpose of the building, preferences of inhabitants, and architectural styling.

To construct a spatial or three-dimensional model of the interior of a building, one can use a paper floor-map originating from, for example, an architect, and digitalize it using a computer-aided design program. A problem however is that such floor-maps may differ from the real-life situation due to changes during the construction phase, or when the building is changed during renovation and/or rebuilding operations.

A floor-plan may also not be present at all. Thus, to either verify an existing floor-plan or drafting one when absent, one could site measuring the interior of the building. This is however a time intensive task and sensitive to errors since it needs to be performed manually. Furthermore, site measuring may even not be practical or even impossible, for example when the dimensions of rooms are very complex and/or spacious.

Another way to construct a spatial model of an interior of a building is using a three-dimensional scanning device configured to scan the interior thereby obtaining the spatial model in a direct way. Such a method is disclosed in US20170263052A1. Herein, an interior of a building is scanned thereby obtaining a point cloud. Next, based on this point cloud, a spatial model is generated. However, a drawback is that the generated spatial model comprises a variety of accessories, as already discussed. The spatial model is thus a distorted image since these accessories may easily be replaced over time. A way to overcome this drawback is to empty the building completely, which is, however impractical and time consuming.

Points in a point cloud from a scanned room may also be labelled into either building points for the structure, either object points for the accessories, thereby making a distinction between the structure and the accessories. The object points may also be labelled as clutter. By making a distinction between these points, a floor plan may be constructed based on the building points, and subsequently wall samples may be generated for such a floor plan thereby obtaining a spatial model. Such a method is disclosed in US20170148211A1. A drawback, however, is that the final spatial model is generated by extruding the floor plan with respect to a ceiling height. As a result, simple vertical walls are assumed, which may not correspond to the real-life situation. Furthermore, another drawback is that points may wrongly be labelled as clutter and thus removed, resulting in a spatial model wherein construction elements are missing.

Another way of constructing a spatial model based on a point cloud is disclosed in Polygonal surface reconstruction from point clouds, L. Nan et. al., published in 2017 IEEE International Conference on Computer Vision (ICCV), pages 2372-2380. Herein, in contrast to the just discussed method, clutter is not eliminated from the point cloud, but a spatial model is generated based on a selection of structural faces from a large number of candidate faces. The structural faces are then assembled thereby obtaining the spatial model. However, a drawback is that degenerate faces are generated, wherein a degenerate face is to be regarded as a face that is not connected with an adjacent face. Because of this, a hypothesis must be made between such a face and a neighbouring one not adjacent to it to generate a watertight mesh. This may then result in a mesh which does not correspond to the real-life situation. Furthermore, another drawback is that a long and very thin structural face may be selected resulting in a large optimization problem hard to solve. Again, this leads to spacious models likewise not corresponding to the real-life situation.

It is therefore an object of the present invention to alleviate the above drawbacks and to provide an improved solution for generating a spatial model of an indoor structure from a point cloud in an efficient manner.

### Summary of the Invention

This object is achieved, in a first aspect, by a computer implemented method for generating a spatial model of an indoor structure from a point cloud, the method comprising the steps of:

- identifying shapes in the point cloud;
- enveloping the shapes by a bounding volume;
- intersecting the bounding volume with planes determined by the shapes, thereby obtaining structural faces; and

- constructing the spatial model by the structural faces.

The point cloud is obtained from a three-dimensional scanning device and comprises points from, for example, a single room or multiple rooms in a building. The scanning device is thus placed within the one or more rooms and generates the point cloud, wherein the points comprises coordinates in, for example, a cartesian coordinate system, or any other coordinate system suitable for representing three-dimensional points. It should be further understood that the point cloud may also be obtained by merging, for example, a set of two-dimensional images originating from a consumer good, such as a smartphone. In other words, the point cloud is considered as an input for the computer implemented method and may be obtained via a variety of methodologies.

As a first step, shapes are identified in the point cloud. Shapes may be two-and/or three-dimensional and are, for example, planar segments or planar primitives, polygons, lines, cylinders and/or spheres. The identifying may, for example, be performed by a random sample consensus, RANSAC, method through which subsets of points from the point cloud fitting a model of geometric primitives are detected. For each of these subsets a best fit shape according to that geometric primitive is identified.

Next, in a second step, the identified shapes from the previous step are enveloped by a bounding volume. In other words, the bounding volume encloses or envelops all the shapes, or even all the points in the point cloud. The bounding volume is, for example, a volume covered by a globe or by an ellipsoid.

Then, in a subsequent step, the bounding volume is intersected with planes determined by the shapes, wherein the planes have a zero curvature or a spherical geometry depending on the shapes determining the planes. In other words, the bounding volume is cut in pieces by planes defined by the shapes, wherein these pieces are intersections of the volume on the one hand and the planes defined or determined by the shapes on the other hand. The intersections are thus two-dimensional shapes, whether curved or not, and are further labelled as structural faces. As a result, a set of structural faces are thus obtained.

Finally, the spatial model of the indoor structure is constructed by using these structural faces. A way to do so is, for example, using solely or mainly structural faces located at the outside, thus structural faces which do not face another structural face on one side. Alternatively, or supplementary, a structural face may intersect another structural face, such that the spatial model is constructed by intersecting the structural faces mutually, wherein the spatial model corresponds to a watertight mesh of these intersected structural faces.

Advantageously, since the spatial model is constructed from a point cloud by scanning a room, it is ensured that the model corresponds to the real-life situation without emptying the room. Next, there is no need of having in advance a floor plan. Secondly, the point cloud only has to comprise coordinates of the points, so per point no additional data is needed. Furthermore, there is also no need the make a distinction between structural points and clutter in the point cloud. Since shapes are identified in the point cloud, such a distinction is made in an indirect way, thereby avoiding that structural points are wrongly labelled as clutter.

Next, by enveloping the shapes identified in the point cloud, a first source of clutter is eliminated, for example originating from a window opening when the room is scanned. Through this window opening points may be detected but which do not form a shape. These points will thus not be enveloped or enclosed. Besides, by enveloping the shapes, it is also ensured that a watertight spatial model is generated.

In a point cloud of a regular room that is scanned, at every side of the room a shape may be detected, wherein a shape may correspond to a part of at least a wall, a ceiling, and/or a floor. This way, a shape may be identified at each side of the room, even when only a part of a shape is visible. Subsequently, be intersecting the bounding volume with planes determined by the shapes, even when parts of the surfaces of the walls, the ceiling and the floor that are not visible are taken into account. The bounding volume is thus intersected and cut into pieces, wherein the intersections are labelled as structural faces and used to construct the spatial model. Moreover, the type and form of the bounding volume may be adapted to the type of the room that is scanned such that the structural faces are obtained in an efficient and fast manner. Finally, by using the structural faces to construct the spatial model, clutter inside the room may also be eliminated by, for example, using the structural faces on the outside. This way, a distinction between structural elements and accessories is made in an indirect manner, thereby reducing the risk that points are wrongly labelled as clutter.

According to an embodiment, the computer implemented method further comprises the step of:

- adding a plane defining a segment of an outer surface of the bounding volume to the structural faces when a distance between the segment and any one of the shapes exceeds a predefined threshold.

Differently formulated, when at a segment of the outer surface no shape is detected, a plane defining this segment is added to the structural faces such that it may be used to generate the spatial model. A shape may be absent when, for example, boundary walls of the scanned room are not captured due to the presence of clutter, door openings, window openings, and other sources causing such a problem. Thus, by adding a plane defining this segment, this problem is alleviated, and it is further ensured that a watertight mesh of the spatial model is generated.

According to an embodiment, the bounding volume is a convex polyhedron, and wherein the intersecting further comprises intersecting the convex polyhedron at a respective vertex when the respective vertex is within a predefined accuracy distance.

Differently formulated, the bounding volume envelopes the shapes by a convex polyhedron, wherein a convex polyhedron is to be regarded as a solid in three dimensions with flat polygonal faces, straight edges and corners or vertices. An example of a convex polyhedron is thus a cube or a bar. This way, a bounding volume may be defined by vertices and to which other vertices they are connected to. Next, by imposing that the polyhedron is intersected at a vertex when said vertex is within a predefined accuracy distance with regard to the intersecting plane, the intersecting step is performed in a fast and efficient manner. The predefined accuracy distance may, for example, be determined by defining a sphere with a vertex as centre point and the predefined accuracy distance as radius. This way, a limit of a floating-point precision is levered in this way, or differently formulated, a floating-point precision problem is avoided. Furthermore, by enveloping the shapes by a convex polyhedron, the resulting structural faces are polygonals, or again convex polyhedrons when intersected with planes, such that the spatial model is constructed in a straightforward manner.

According to an embodiment, the intersecting further comprises intersecting the convex polyhedron by planes parallel to the planes determined by the shapes at the predefined accuracy distance at both sides of the planes.

In other words, the planes determined by the shapes are offset at both sides, such that the convex polyhedron is intersected with two parallel planes. As a result, the obtained structural faces have a thickness corresponding to twice the predefined accuracy distance, since for each plane determined by a shape the bounding volume or convex polyhedron is intersected twice. Advantageously, the spatial model constructed by these structural faces comprises sides with a thickness, which is more representative for a real-life situation.

Further, by intersecting the convex polyhedron by parallel planes, a vertex lying between these planes will be considered as the intersecting point, such that in this way the predefined accuracy distance is also taken into account.

According to an embodiment, the computer implemented method further comprises the step of:

- ordering vertices of the convex polyhedron in a lexicographically order; and wherein the intersecting is performed in the lexicographically order.

This way, by ordering the vertices of the convex polyhedron in a lexicographically order vertices are intersected by the planes in a consistent manner, namely by taking into account the ordering of the vertices. Differently formulated, an intersection is performed by first comparing x-coordinates in an ordered manner, then y-coordinates in an ordered manner, and finally z-coordinates in an ordered manner. Alternatively, another coordinate system, such as a spherical coordinate system, may be used to compare coordinates in a systematic order. By performing the intersecting step through this way, another source of limiting a precision due to floating points is tackled as well, since, comparing points in one direction may result in a different result when comparing the points in the opposite direction. Hence, a numerically robust method of intersecting the bounding volume is obtained. The ordering may be performed temporarily each time an intersecting step is performed and prior hereto

According to an embodiment, the intersecting further comprises rejecting a structural face when the structural face is duplicate.

When intersecting the bounding volume by the planes determined by the shapes, or by planes parallel hereon, duplicate structural faces may be obtained. This may occur, for example, when different identified shapes determine a same plane, or when parallel planes are used to intersect the bounding volume. Through the latter intersecting step, two structural faces are obtained, one facing to the inside of the scanned room, and one facing to the outside of the scanned room, which are also considered as duplicate. The structural faces facing to the outside of the scanned room may then be rejected. Advantageously, by rejecting duplicate faces and/or faces pointing to the outside when a parallel face is pointing to the inside, a unique set of structural faces is obtained, such that the spatial model is constructed in a straightforward and unique manner.

According to an embodiment, the constructing further comprises selecting structural faces by weighting for a structural face a number of points in the structural face over the number of points in the point cloud, and wherein the spatial model is constructed by the selected structural faces.

Thus, when constructing the spatial model by the structural faces, a subset of the set of structural faces may be selected by which the model is constructed. A first way to select structural faces for the subset is by evaluating how many points of the point cloud are within a structural face weighted over the total number of points in the point cloud. This way, it is ensured that structural faces comprising at least a minimum amount of inside points or inliers over the total number of points in the point cloud are selected, since the likelihood that they represent a surface is higher compared to structural faces comprising only a few inliers compared to the total number of points in the point cloud.

According to an embodiment, the weighting further comprises weighting for a structural face a number of boundary edges adjacent to non-coplanar structural faces over the number of edges.

Alternatively, or additionally, in a second criterion, the weighting is based on a number of boundary edges, which is a measure for the complexity of the resulting constructed spatial model. An edge is a boundary edge if the two structural faces adjacent to this edge do not lie in a same plane, thus are non-coplanar. Thus, the less boundary edges selected structural faces comprise, the less complex the resulting constructed spatial model will be, which is achieved by selecting through weighting the structural faces having a small ratio of the number of boundary edges over the total number of edges. These selected structural faces are then used, in case combined with the structural faces selected through the number of inliers, to construct the spatial model. Furthermore, this way, the type of the scanned room or rooms may be taken into account as well.

According to an embodiment, the weighting further comprises weighting for a structural face a number of points of the point cloud faced by the structural face over a surface covered by the bounding volume.

A third selecting criterion is selecting structural faces which are located at the outside, but close enough to the inside to still cover the interior of the scanned room. To balance between these to constraints, structural faces are selected that are facing at least a number of points on one side, which is the side facing to the inside of the room, thus the midpoint of the point cloud. This is achieved by weighting for a structural face the number of points it is facing over the surface covered by the bounding volume.

According to an embodiment, the weighting further comprises weighting for a structural face the number of points in the structural face over the number of points in the point cloud, the number of boundary edges adjacent to non-coplanar structural faces over the number of edges and/or the number of points of the point cloud faced by the structural face over a surface covered by the bounding volume.

In other words, the three selecting weighting criterions may be combined by weighting the different parameters relatively to each other. These parameters are the number of points in the structural face over the number of points in the point cloud, the number of boundary edges adjacent to non-coplanar structural faces over the number of edges, and the number of points of the point cloud faced by the structural face over a surface covered by the bounding volume. Advantageously, this way the type of the scanned room may be taken into account. For example, if a room comprises a lot of corners and sides the number of boundary edges adjacent to non-coplanar structural faces over the total number of edges may be given a higher weighting to take into account the complexity of the room. Another example is the functionally of the room that is scanned, which may likewise be taking into account. If, for example, a working place is scanned comprising few accessories, the number of points or inliers in the structural face may be given priority in a higher manner, compared to the situation wherein, for example, a living room is scanned comprising a variety of furniture and other accessories.

According to an embodiment, the selecting further comprises imposing a 2-manifold constraint and/or an orientation constraint.

Besides or combined with selecting structural faces based on the number of points in the structural face over the number of points in the point cloud, the number of boundary edges adjacent to non-coplanar structural faces over the number of edges, and the number of points of the point cloud faced by the structural face over a surface covered by the bounding volume, the selecting may further comprise imposing constraints. A first constraint is a 2-manifold constraint to guarantee that the constructed spatial model is 2-manifold, in other words, that the spatial model has a surface corresponding to the real-life situation of the scanned room. Another constraint that may be imposed is an orientation constraint. The orientation constraint ensures that a structural face is selected with an edge in one direction, while an adjacent face is selected with an edge in the opposite direction. The union of the selected structural faces then result in a final constructed spatial model.

According to an embodiment, the method further comprises the step of down sampling the point cloud prior to the identifying.

Thus, prior to the identifying of shapes through, for example, a RANSAC method, the point cloud is first filtered. The filtering is performed by down sampling the input point cloud using a voxel grid filter at a predefined resolution. This way, by this first filtering step, a part of clutter may already be eliminated such that the preceding steps are performed in a fast and efficient manner.

According to a second aspect, the invention relates to a data processing system comprising means for carrying out the method according to the first aspect.

According to a third aspect, the invention relates to a computer program product comprising instructions which, when the program is executed on a computer, cause the computer to carry out the method according to the first aspect.

According to a fourth aspect, the invention relates to a computer-readable storage medium comprising instructions, when executed by a computer, cause the computer to carry out the steps of the method according to the first aspect.

## Brief Description of the Drawings

Some example embodiments will now be described with reference to the accompanying drawings.

Fig. 1 illustrates a point cloud obtained from a three-dimensional scanning device;

Fig. 2 illustrates planar primitives extracted from the point cloud as illustrated in Fig. 1 and Fig. 2;

Fig. 3 illustrates a bounding volume enveloping detected shapes within the point cloud as illustrated in Fig. 1;

Fig. 4 illustrates the bounding volume illustrated in Fig. 3 intersected by planes;

Fig. 5 illustrates a generated spatial model from the point cloud illustrated in Fig. 1;

Fig. 6 illustrates an apparatus comprising means configured to generate a spatial model of an indoor structure from a point cloud;

Fig. 7A illustrates clipping a convex polygon by a plane;

Fig. 7B illustrates an ordering of faces among an edge;

Fig. 8 illustrates a computer system that can be configured to execute one or more embodiments of the method for generating a spatial model; and

Fig. 9 illustrates a cloud-interface to execute one or more embodiments of the method for generating a spatial model.

**Detailed Description of Embodiment(s)**

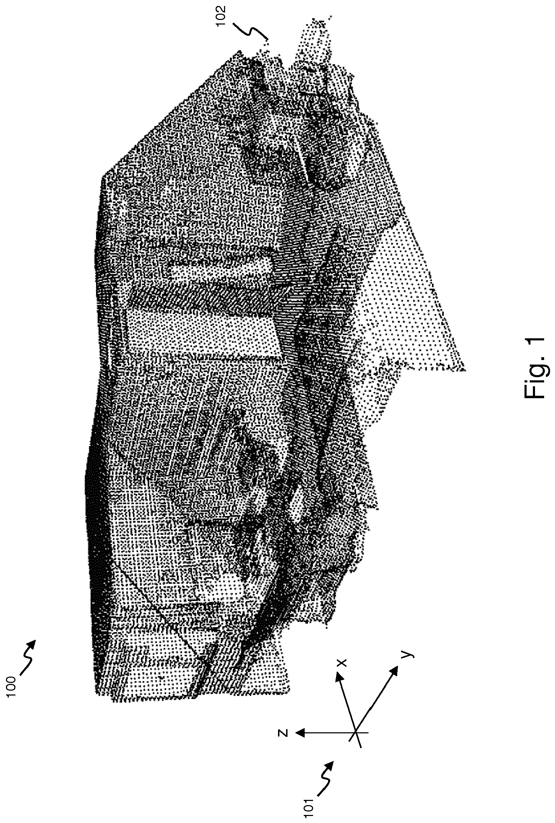

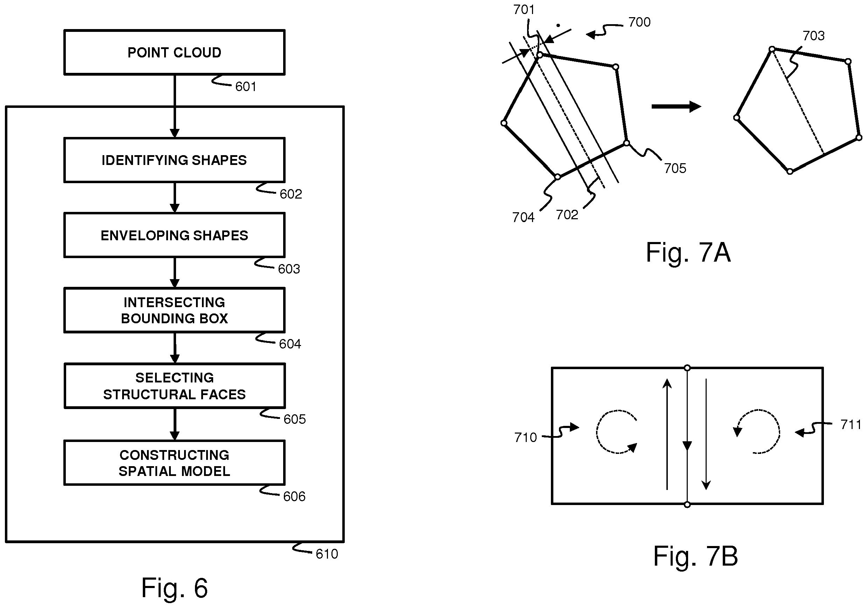

Fig. 1 illustrates a point cloud from a scanned structure. The point cloud 100 may be obtained from, for example, a three-dimensional scanning device suitable to scan an indoor structure and to derive therefrom a point cloud such as point cloud 100. The point cloud 100 may, for example, be represented in a three-dimensional cartesian coordinate system 101, or any other coordinate system suitable for representing a three-dimensional point cloud 100. The point cloud 100 comprises points such as point 102. Each point is thus identifiable through its coordinate. From the point cloud 100, which is considered as an input, a spatial model will be generating therefrom. Fig. 6 illustrates an apparatus comprising means configured to generate such a spatial model, wherein the point cloud 100 is considered to be an input 601 for the apparatus 610. The input 601 point cloud 100 may be a point cloud of an entire room, including furniture and other objects.

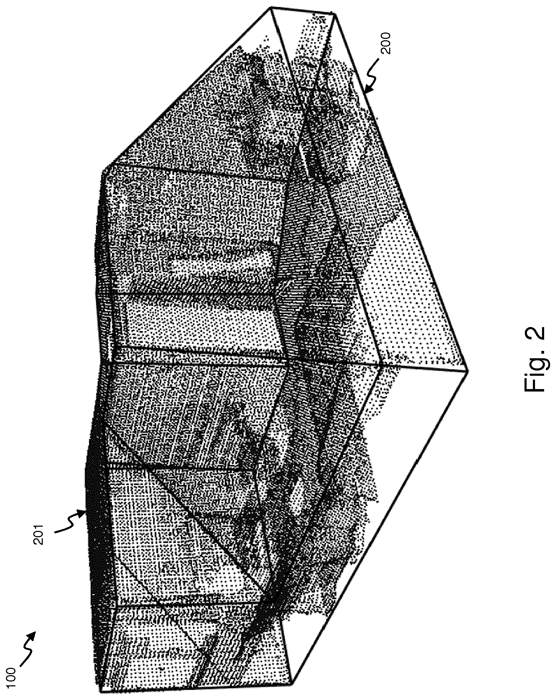

In a first step, in the point cloud 100 shapes are identified 602 by extracting planar primitives from the input point cloud 100. To identify 602 or detect planar primitives in the three-dimensional point cloud 100, a random sample consensus (RANSAC) method may be used. Firstly, the point cloud 100 may be down sampled using a voxel grid filter at a resolution of, for example, $5cm$. As a result, a set of planar patches $P = \{p_i\}$ is obtained, wherein each patch comprises a set of points $p_i$ which lie within a distance $\varepsilon$ from a best fit plane through these points. Planar primitives identified or extracted from the point cloud 100 are illustrated in Fig. 2 by, for example, line 200 and plane 201.

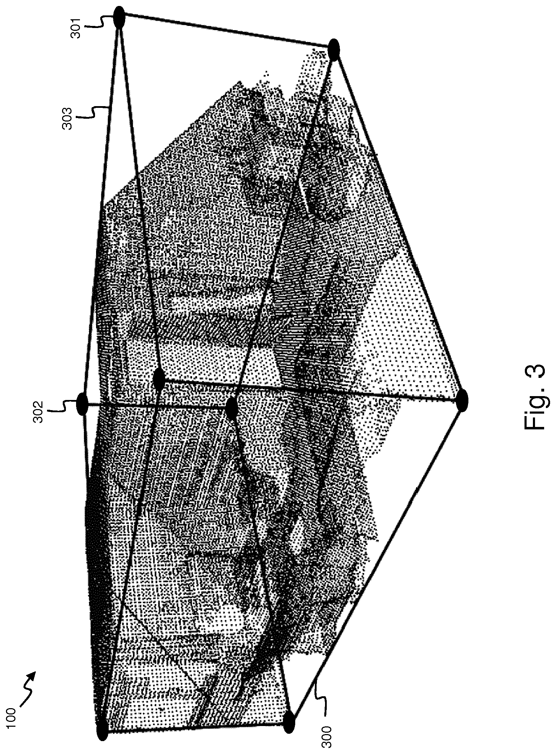

Next, the identified 602 shapes such as line 200 and plane 201 in the point cloud 100 are enveloped 603 by a bounding box as illustrated in Fig. 3 by bounding box 300. In this illustrative example, the bounding box 300 is a cuboid comprising vertices, such as vertices 301 and 302 connected by edge 303.

The bounding box 300 enveloping 603 the point cloud 100 may be defined such that the planes of the bounding box 300 are close to the limits of the point cloud 100 such as illustrated by bounding box 300. Alternatively, a bounding box may also envelop the point cloud 100 wherein the planes thereof are located at a distance from points located at the edge of the point cloud 100.

When the bounding box 300 is close to the edges of the point cloud 100, planes may be added to the set of planar patches as obtained in the previous step 602. For example, when the set of planar patches does not comprise a plane that is located within a predefined distance from a segment of the outer surface of the bounding box 300, the plane defining the segment of the bounding box 300 is added to the set of planar patches. This way, it is ensured that a watertight mesh will be generated.

The just mentioned absence of such a plane may occur when a boundary wall of the scanned structure is undetected due to the presence of clutter, door openings, etc.

A plane of the bounding box 300 may also be close to a plane of the set of planar patches, such that both planes may be considered as equal. To verify if a plane of the set is close to a plane of the bounding box, firstly angles between the detected planes and the bounding box planes are determined. Next, a plane having an angle with a plane of the bounding box lower than a predefined threshold $\theta_t$ and comprising a predefined number of points $n_t$ lying on the bounding box plane is considered to be equal to the bounding box plane. The thresholds $\theta_t$ and $n_t$ may, for example, be set at 10° respectively 20%$|p_i|$ wherein $|p_i|$ denotes the number of inliers of the planar patch $p_i$. When a plane of the bounding box does not have a corresponding plane in the set, it may be added to the set as already highlighted.

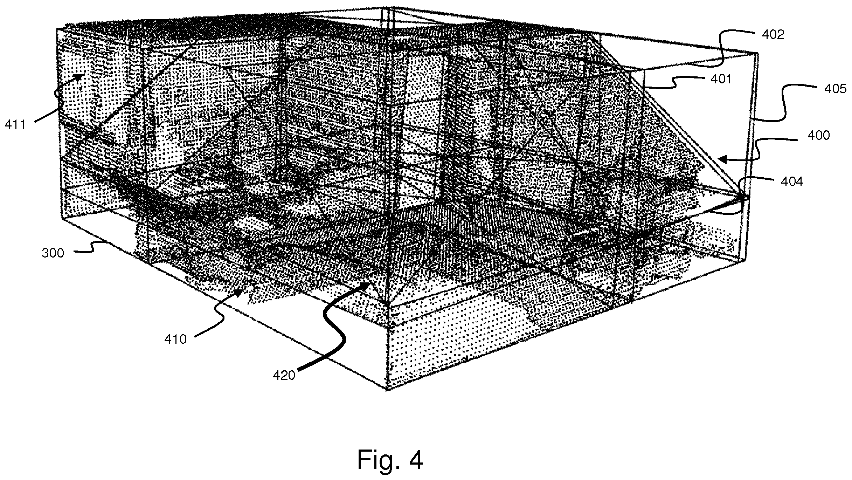

Next, the bounding box 300 is intersected 604 by the planes determined by the shapes in the set. This is illustrated in Fig. 4. To account for numerical robustness, an intersection point is calculated by the ordering points. For example, as illustrated in Fig. 7A, when calculating an intersection between line 702 and a line from point 704 to point 705, a different outcome may be obtained when the intersection is calculated by going from point 705 to point 704 due to a limited precision of floating points. Thus, to avoid numerical issues, the points are ordered lexicographically. This means that first x-coordinates are compared, if they are equal y-coordinates are compared, and finally if they are also equal z-coordinates are compared.

Secondly, another source of numerical issues may arise when checking if a point lies in front or behind a plane, which is tackled by slicing a plane but two planes lying parallel to said plane at, for example, a distance $\varepsilon$. For example, although vertex 701 is not intersected by a plane that may be identified by line 702, it lies within the distance $\varepsilon$ 700 from vertex 701 such that intersection 703 is performed at vertex 701.

Thus, the bounding volume 300 is intersected 604 with all the detected planes resulting in intersections like, for example, intersections 401-405 and 420. As a result, structural faces are obtained, such as structural faces 400, 410 and 411. From this set of structural faces, a selection 605 is made from which the spatial model is constructed 606.

When, for example, duplicate faces are obtained, only one unique structural face replaces those duplicate faces. The set of selected structural faces may also comprise faces that were previously added when the set of planar patches does not comprise a plane that is located within a predefined distance from a plane of the bounding box 300.

The selection 605 of the structural faces is performed in such a way that it best describes the geometry of the scanned structure, while simultaneously guaranteeing that the resulting spatial model is 2-manifold and oriented. This may be achieved by formulating the selection 605 as a binary labelling problem.

Firstly, each structural face, represented as $f_i$ is described by two variables $x_i$ and $x_{ir}$, wherein the subscript $r$ signifies reverse, meaning that either a face in its counter clockwise orientation, i.e. $x_i = 1$, either in its clockwise or reversed orientation, i.e. $x_{ir} = 1$, is selected. When a face is not selected at all, its respective variables are set at zero. Next, the structural faces are selected through three energy terms: data selection, model complexity and interior coverage.

The data selection term evaluates how many points belong to the planar patches through:

$$E_d = -\frac{1}{|P|} \sum_{i=1}^{N} (x_i + x_{ir}) . inliers(f_i) \tag{Eq.1}$$

wherein $P$ is the total number of inliers from the detected planar patches and $inliers(f_i)$ is the number of inliers in face $f_i$ and $N$ is the total number of generated faces. The term $E_d$ favours selecting as many faces wherein planar patches are identified.

A second term, the model complexity, discourage selecting structural faces corresponding to clutter by taking into account the number of boundary edges of a structural face. The model complexity term is expressed as follows:

$$E_c = \frac{1}{|E|} \sum_{i=1}^{N} \sum_{j=1, i \neq j}^{N} (x_i + x_{ir})(x_j + x_{jr}) . corner(f_i, f_j) \tag{Eq.2}$$

wherein E is the total number of edges and $corner(f_i, f_j)$ indicates whether the edge formed by the faces $f_i$ and $f_j$ is a boundary edge, i.e. $corner(f_i, f_j) = 1$ or not.

The third term, the interior coverage compensates the fact that clutter results in missing data. This is achieved by selecting structural faces that covers more points on the inside compared to the outside. To measure a coverage of a face $f_i$, firstly all points that lie in front of $f_i$ are projected. Hence, for $x_i$ points are projected on the positive side of the supporting plane onto $f_i$ and for $x_{ir}$ points are projected on the negative side onto $f_i$. Next, a two-dimensional alpha shape from the projected points is calculated. The alpha shape creates a bounding area that envelops the set of projected two-dimensional projected points. By changing the alpha parameter, the alpha shape object is manipulated to tighten or loosen a fit around the points to create a non-convex region. The alpha shape provides a good measure for the coverage of the candidate face by the projected points. Thus, even if a face $f_i$ from a structural component has no inliers due to occlusion, there will be a lot of points in front of it. Hence, it can still provide a high coverage and gets a higher chance of being selected as well.

The interior coverage term is expressed as:

$$E_i = -\frac{1}{|area(M)|}\sum_{i=1}^{N} x_i.\left(area(f_i) - area_P(f_i)\right) + x_{ir}.\left(area(f_i) - area_N(f_i)\right) \qquad \text{(Eq.3)},$$

wherein $area(M), area(f_i), area_P(f_i)$ and $area_N(f_i)$ denote the surface areas of the bounding box 300, a candidate face $f_i$, and the area of the alpha shape mesh constructed from the points on the positive or negative side of $f_i$ respectively.

Subsequently, an optimal subset of candidate structural faces is selected 605 my minimizing a weighted sum of the data selection, model complexity and interior coverage terms expressed by equations one to three. Since for a face $f_i$ only one orientation can be selected, the variables $x_i$ and $x_{ir}$ are mutually exclusive. This mutual exclusion can be enforced by adding an extra term to an objective function calculating a weighted sum of the terms, namely variables $x_i x_{ir}$. This term ensures that either one or both variables will be zero. The objective term is formulated as follows:

$$E = \lambda_d.E_d + \lambda_c.E_c + \lambda_i.E_i + \sum_{i=1}^{N} x_i x_{ir} \qquad \text{(Eq.4)},$$

with $0 \le x_i x_{ir} \le 1$. Thus, by defining the two variables per face, it is ensured that the constructed spatial model 606 will have a consistent orientation. The orientation of two adjacent faces is consistent when two vertices of the common edges are in an opposition direction. This is illustrated in Fig. 7B by 710 and 711.

The vertices of each edge are further lexicographically ordered, so for each face $f_i$ adjacent to an edge $e_j$ its direction can be determined with respect to this edge. Thus, functions $sign(x_i, e_j)$ and $sign(x_{ir}, e_j)$ are defined as follows:

$$sign(x_i, e_j) \qquad \text{(Eq.5)},$$

$$= \begin{cases} 1 \ if \ e_j \ and \ corresponding \ edge \ in \ x_j \ have \ the \ same \ direction \\ -1 \ if \ e_j \ and \ corresponding \ edge \ in \ x_j \ have \ opposite \ directions \end{cases}$$

and:

$$sign(x_{ir}, e_j) = -sign(x_i, e_j) \qquad \text{(Eq.6)}.$$

Next, to ensure that each edge will have consistently oriented faces, the following constraint is defined:

$$\forall e_j: \sum_{f_i \in \mathcal{N}(e_j)} sign(x_i, e_j).x_i + sign(x_{ir}, e_j).x_{ir} = 0 \qquad \text{(Eq.7)},$$

which implies that when a face is selected with the edge in one direction, another face should be selected with the edge in the opposite direction.

Further, to guarantee that the constructed spatial model is 2-manifold either two or no faces must be selected. Therefore, an additional constraint for each edge is defined as:

$$\forall e_j: \sum_{f_i \in \mathcal{N}(e_j)} x_i + x_{ir} \le 2 \qquad \text{(Eq.8)}.$$

Finally, the optimization problem for selecting the best subset of candidate faces can be formulated as follows:

$$min_{x_i,x_{ir}} \ \lambda_d.E_d + \lambda_c.E_c + \lambda_i.E_i + \sum_{i=1}^{N} x_i x_{ir} \qquad \text{(Eq.9)},$$

such that

$$
\begin{cases}
\displaystyle\sum_{f_i \in \mathcal{N}(e_j)} sign(x_i, e_j).x_i + sign(x_i, e_j).x_{ir} = 0, \\[4mm]
\displaystyle\sum_{f_i \in \mathcal{N}(e_j)} x_i + x_{ir} \leq 2, \\[2mm]
0 \leq x_i, x_{ir} \leq 1,
\end{cases}
\qquad \text{(Eq.10).}
$$

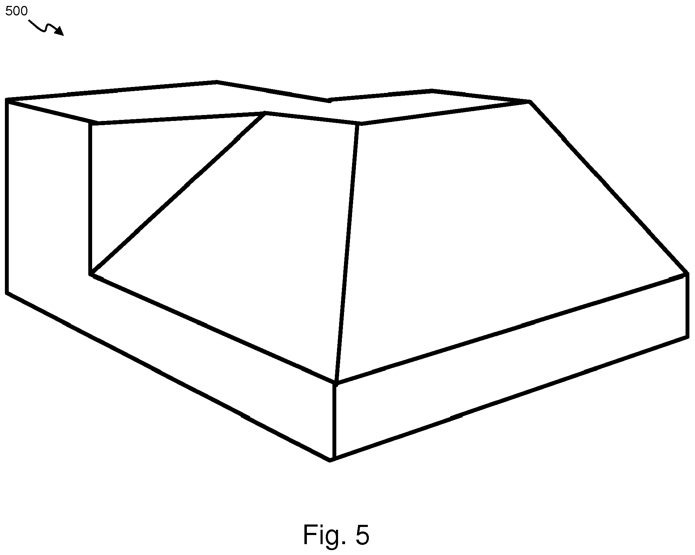

Finally, when the structural faces are selected 605, the spatial model is constructed 606 based on this selection 605 of structural faces. A constructed 605 spatial model is illustrated in Fig. 5, by spatial model 500 which represents the structure that is scanned and from which point cloud 100 was obtained and used as an input 601 to the apparatus 610.

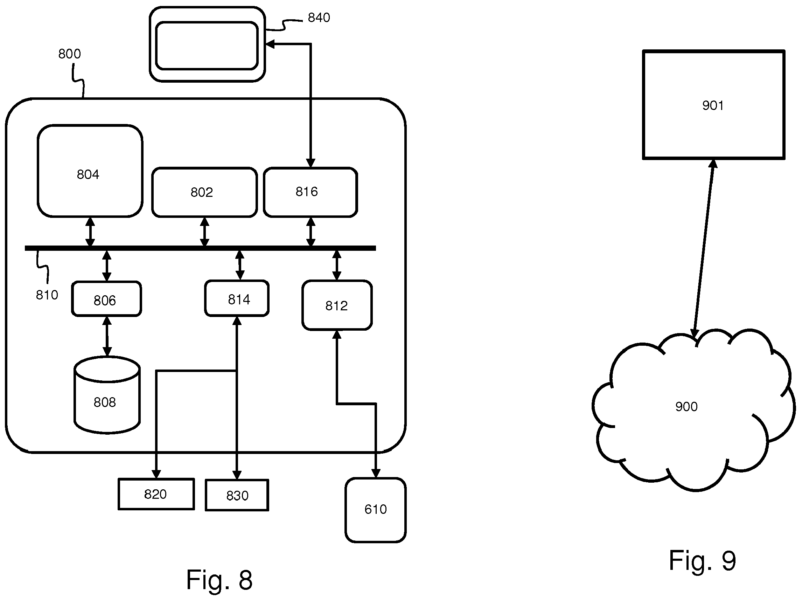

Fig. 8 shows a suitable computing system 800 for performing the steps according to the above embodiments. Computing system 800 may be used for generating a spatial model 500. Computing system 800 may in general be formed as a suitable general-purpose computer and comprise a bus 810, a processor 802, a local memory 804, one or more optional input interfaces 814, one or more optional output interfaces 816, a communication interface 812, a storage element interface 806 and one or more storage elements 808. Bus 810 may comprise one or more conductors that permit communication among the components of the computing system 800. Processor 802 may include any type of conventional processor or microprocessor that interprets and executes programming instructions. Local memory 804 may include a random-access memory (RAM) or another type of dynamic storage device that stores information and instructions for execution by processor 802 and/or a read only memory (ROM) or another type of static storage device that stores static information and instructions for use by processor 802. Input interface 814 may comprise one or more conventional mechanisms that permit an operator to input information to the computing device 800, such as a keyboard 820, a mouse 830, a pen, voice recognition and/or biometric mechanisms, etc. Output interface 816 may comprise one or more conventional mechanisms that output information to the operator, such as a display 840, etc. Communication interface 812 may comprise any transceiver-like mechanism such as for example one or more Ethernet interfaces that enables computing system 860 to communicate with other devices and/or systems such as apparatus 610. The communication interface 812 of computing system 800 may be connected to such another computing system by means of a local area network (LAN) or a wide area network (WAN) such as for example the internet. Storage element interface 606 may comprise a storage interface such as for example a Serial Advanced Technology Attachment (SATA) interface or a Small Computer System Interface (SCSI) for connecting bus 610 to one or more storage elements 808, such as one or more local disks, for example SATA disk drives, and control the reading and writing of data to and/or from these storage elements 808. Although the storage elements 808 above is described as a local disk, in general any other suitable computer-readable media such as a removable magnetic disk, optical storage media such as a CD or DVD, -ROM disk, solid state drives, flash memory cards, ... could be used. The system 800 described above can also run as a virtual machine above the physical hardware.

The steps according to the above embodiments may be performed on computing system 800. Computing system may interact directly with a user, e.g. through the interfaces 820, 830 and represent the results of the steps according to the above embodiments on a display 840 or print them on a printer 650. Alternatively, as illustrated in Fig. 9, the steps may be performed remote from a user on a remote computing system 900, e.g., on a cloud computing system. Interaction with a user may then be done by a connection between the remote computing system 900 and a client computing system 901, e.g. over an Internet connection. Also, the client computing system 901 may be implemented as computing system 800. Communication is then performed over a wired or wireless networking interface 812.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

**Claims**

1. A computer implemented method for generating a spatial model (500) of an indoor structure from a point cloud (100), the method comprising the steps of:

   - identifying (602) shapes in the point cloud (100);
   - enveloping (603) the shapes by a bounding volume (300);
   - intersecting (604) the bounding volume (300) with planes determined by the shapes, thereby obtaining structural faces (400, 410, 420); and
   - constructing (606) the spatial model (500) by the structural faces.

2. The computer implemented method according to claim 1, further comprising the step of:

   - adding a plane defining a segment of an outer surface of the bounding volume (300) to the structural faces when a distance between the segment and any one of the shapes exceeds a predefined threshold.

3. The computer implemented method according to any one of the claims 1 to 2, wherein the bounding volume (300) is a convex polyhedron, and wherein the intersecting further comprises intersecting the convex polyhedron at a respective vertex (701) when the respective vertex (701) is within a predefined accuracy distance (700).

4. The computer implemented method according to claim 3, wherein the intersecting further comprises intersecting the convex polyhedron by planes parallel to the planes determined by the shapes at the predefined accuracy distance at both sides of the planes.

5. The computer implemented method according to any one of the claims 3 to 4, further comprising the step of:

   - ordering vertices of the convex polyhedron in a lexicographically order;

   and wherein the intersecting further is performed by the lexicographically order.

6. The computer implemented method according to any one of the preceding claims, wherein the intersecting further comprises rejecting a structural face when the structural face is duplicate.

7. The computer implemented method according to any one of the preceding claims, wherein the constructing further comprises selecting structural faces by weighting for a structural face a number of points in the structural face over the number of points in the point cloud (100), and wherein the spatial model (500) is constructed (606) by the selected structural faces.

8. The computer implemented method according to claim 7, wherein the weighting further comprises weighting for a structural face a number of boundary edges adjacent to non-coplanar structural faces over the number of edges.

9. The computer implemented method according to any one of the claims 7 to 8, wherein the weighting further comprises weighting for a structural face a number of points of the point cloud (100) faced by the structural face over a surface covered by the bounding volume (300).

10. The computer implemented method according to any of the claims 7 to 9, wherein the weighting further comprises weighting for a structural face the number of points in the structural face over the total number of points in the point cloud (100), the number of boundary edges adjacent to non-coplanar structural faces over the number of edges and/or the number of points of the point cloud faced by the structural face over a surface covered by the bounding volume.

**11.** The computer implemented method according to any one of the claims 7 to 10, wherein the selecting further comprises imposing a 2-manifold constraint and/or an orientation constraint.

**12.** The computer implemented method according to any one of the preceding claims, the method further comprising the step of down sampling the point cloud prior to the identifying.

**13.** A data processing system comprising means for carrying out the method of any of the preceding claims.

**14.** A computer program product comprising instructions which, when the program is executed on a computer, cause the computer to carry out the method of any of the claims 1 to 12.

**15.** A computer-readable storage medium comprising instructions, when executed by a computer, cause the computer to carry out the steps of the method of any of the claims 1 to 12.

Fig. 1

Fig. 2

Fig. 3

Fig. 4

500

Fig. 5

Fig. 7A

Fig. 7B

POINT CLOUD — 601

IDENTIFYING SHAPES — 602

ENVELOPING SHAPES — 603

INTERSECTING BOUNDING BOX — 604

SELECTING STRUCTURAL FACES — 605

CONSTRUCTING SPATIAL MODEL — 606

610

Fig. 6

EP 3 620 941 A1

840

800

804

802

816

810

806

814

812

808

820

830

610

Fig. 8

901

900

Fig. 9

Europäisches
Patentamt

European
Patent Office

Office européen
des brevets

## EUROPEAN SEARCH REPORT

Application Number

EP 18 19 2627

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NAN LIANGLIANG ET AL: "PolyFit: Polygonal Surface Reconstruction from Point Clouds", 2017 IEEE INTERNATIONAL CONFERENCE ON COMPUTER VISION (ICCV), IEEE, 22 October 2017 (2017-10-22), pages 2372-2380, XP033283101, DOI: 10.1109/ICCV.2017.258 [retrieved on 2017-12-22] * abstract * * page 2373, column 2, paragraph 3 - page 2374, column 1, paragraph 1; figure 1 * * page 2374, column 2, paragraph 2-3; figure 2 * * page 2376, column 1, paragraph 3 * * page 2376, column 2, paragraph 2; figure 4 * * page 2378, column 1, last paragraph - column 2, paragraph 1; figure 7 * ----- | 1-15 | INV. G06F17/50 G06T7/11 G06T7/143 |
| A | US 2017/316115 A1 (LEWIS JEFFERY D [US] ET AL) 2 November 2017 (2017-11-02) * abstract * * paragraph [0029] - paragraph [0039] * * paragraph [0041] * * paragraph [0046] * * paragraph [0049] * * paragraph [0056] - paragraph [0057] * ----- | 1-15 | |
| | | | TECHNICAL FIELDS SEARCHED (IPC) |
| | | | G06F G06T |

The present search report has been drawn up for all claims

| Place of search | Date of completion of the search | Examiner |
|---|---|---|
| Munich | 3 April 2019 | Sohrt, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 19 2627

This annex lists the patent family members relating to the patent documents cited in the above-mentioned European search report.
The members are as contained in the European Patent Office EDP file on
The European Patent Office is in no way liable for these particulars which are merely given for the purpose of information.

03-04-2019

| Patent document cited in search report | | | Publication date | Patent family member(s) | | Publication date |
|---|---|---|---|---|---|---|
| US 2017316115 | A1 | | 02-11-2017 | AU 2016366537 A1 | | 14-06-2018 |
| | | | | CA 3007968 A1 | | 15-06-2017 |
| | | | | EP 3387623 A1 | | 17-10-2018 |
| | | | | US 2017316115 A1 | | 02-11-2017 |
| | | | | WO 2017100658 A1 | | 15-06-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170263052 A1

- US 20170148211 A1

**Non-patent literature cited in the description**

- **L. NAN.** Polygonal surface reconstruction from point clouds. *IEEE International Conference on Computer Vision (ICCV),* 2017, 2372-2380